# EUROPEAN PATENT APPLICATION

(11) **EP 4 310 908 A2**
(43) Date of publication of application: **24.01.2024**
(21) Application number: 23186436.4
(22) Date of filing: 19.07.2023
(51) Int. Cl.: H01L 23/495, H01L 23/31, H01L 23/538, H01L 23/00, H01L 23/057, H01L 23/492

(54) **POWER PACKAGE WITH COPPER PLATING AND MOLDING STRUCTURE**

(30) Priority: 22.07.2022 US 202263369197 P; 14.07.2023 US 202318352962
(71) Applicant: STMicroelectronics Pte Ltd., Singapore 569508 (SG)
(72) Inventor: RENARD, Loic Pierre Louis, 319581 SINGAPORE (SG)
(74) Representative: Casalonga

(57) **Abstract**

The present disclosure is directed to a power package with copper plating terminals. The power package includes at least two terminals coupled to a semiconductor die. An area of a first terminal is greater than an area of a second terminal. The first and second terminals extend to a first and second conductive layers in a backside of the package. A third conductive layer is coupled to a backside surface of the die that is coplanar with the first and second conductive layers. The terminals and conductive layers are copper plating. A first molding compound covers the die and terminals, while a second molding compound fills distances between the die and the extensions of the terminals. The copper plating and the molding compounds enhance the performance of the packaged device in a high-power circuit. In addition, robustness of the package is enhanced compared with conventional packages including wire bonding.

## Description

### BACKGROUND

### Technical Field

The present disclosure is directed to a power package including a semiconductor die coupled to a plurality of contacts with copper plating supported by molding compounds instead of wire-bonding.

### Description of the Related Art

Generally, semiconductor devices include a die of processed semiconductor wafer that is protected inside a package. The semiconductor die can be encapsulated inside the package to prevent any potential damages during handling and mounting on a circuit. Terminals of the semiconductor die are extended out of the package through a plurality of conductive interconnections. A typical package has multiple conductive contacts to be mounted on a circuit or printed circuit board by soldering or other mounting techniques. The conductive interconnections carry electrical currents between the semiconductor die and the contacts mounted on the circuit.

The semiconductor die and the conductive interconnections typically are surrounded by an insulator material such as plastics and polymers inside the package. The insulator material, known as molding compound, having small filler sizes, great spiral flow and can be electrically stable at high temperatures. The molding compound protects the semiconductor die and interconnections from any mechanical disturbance. In addition, the molding compound can provide heat dissipation and moisture isolation around the semiconductor die and the conductive interconnections. In particular, by increasing electrical power of the semiconductor device and consequently increasing electrical current passing through the conductive interconnections, excessive heat generation can limit performance of the semiconductor device. In such a fashion, heating dissipation of the conductive interconnection affects the performance and efficiency of the semiconductor device.

The conductive interconnections are typically made from gold, copper, or aluminum wires to bond the terminals on the die to the package contacts. A thicker interconnection can carry greater electrical current and generate less heat with a lower electrical resistance. Thus, the wire of interconnections, as the thinnest conductive pass in a circuit, limits maximum electrical power of the device. Reducing electrical resistance of the interconnections as well as surrounding the conductive materials with a molding compound to increase heat dissipation can enhance the maximum electrical power of the device. The maximum electrical power is an important parameter of device in a high-power circuit.

### BRIEF SUMMARY

The present disclosure is directed to a power package with conductive or copper plating terminals. The power package may be a surface mount device (SMD) with backside contacts. In some embodiments, the power package may be a quad-flat no-leads (QFN) package with planar contacts. The QFN packages can be mounted on a circuit without through-holes. Typically, the QFN package includes a semiconductor die encapsulated inside a non-conductive material to improve heat transfer for high-power applications.

In some embodiments, the power package includes a semiconductor die with a first surface and a second surface. A first terminal and a second terminal are coupled to the first surface of the die. An area of the first terminal is greater than an area of the second terminal. The first and second terminals are formed with a conductive material such as copper. The first and second terminals extend past the second surface of the die. An extension of the first terminal is in an opposite direction to an extension of the second terminal. The first surface of the die, first and second terminals, and first and second extensions are covered with a first molding compound. A first conductive layer is coupled to the second surface of the die. A second conductive layer is coupled to the first extension and a third conductive layer is coupled to the third extension. The first, second, and third conductive layers can be coplanar. An outside surface of the first, second, and third conductive layers is covered with a tin (Sn) layer to prepare the package to be mounted on a surface of a circuit. A distance between the die and the first extension and a distance between the die and the second extension are filled with a second compound.

The first and second terminals, the first and second extensions, and first, second, and third conductive layers can be formed with copper plating. In this fashion, the extensions are used instead of wire bonding in conventional packaging techniques. The copper plating can handle higher electrical current flow than a wire bonding. A wider cross section of conductive extensions compared with the conventional wire bonding reduces an electrical resistance that consequently reduces heat generation in operation mode. The first and second molding compound enhance a heat dissipation of the terminals and the extensions to enable the device to work at a higher maximum power. In addition, the second molding compound can reduce excessive mechanical stress on the first and second extensions during the manufacturing or handling process. A wider area of the first terminal and the corresponding extension and conductive layer compared with the second terminal, can provide greater electrical flow with less heat generation when the first terminal is coupled to high power external contacts.

### BRIEF DESCRIPTION OF THE SEVERAL VIEWS OF THE DRAWINGS

Aspects of the present disclosure are best understood from the following detailed description when read with the accompanying figures. It is noted that various features are not drawn to scale.
Figure 1A is a top plan view of a power package with two terminals;
Figure 1B is a cross-section view of the power package in Figure 1A;
Figure 2A is a top plan view of a plurality of die positioned on a tape;
Figure 2B is a cross-section view of the plurality of die positioned on the tape in Figure 2A;
Figures 3A-3C are steps of forming a molding compound around the plurality of die and shaping the molding compound in a molding assembly;
Figures 4A-4B are steps of removing the tape and changing an orientation of the plurality of die in Figures 2A-2B;
Figure 5A-5B are top plan and cross-sectional views of a die from the plurality of die in Figure 4B at various stages of a formation process;
Figures 6A-6C and 7A-7C are further steps of the formation process of Figures 5A-5B;
Figure 8 is a flowchart of a method of forming a power package according to the present disclosure; and
Figures 9A-9C and Figure 10 are cross-sectional views of a die formed in accordance with an embodiment of this disclosure.

### DETAILED DESCRIPTION

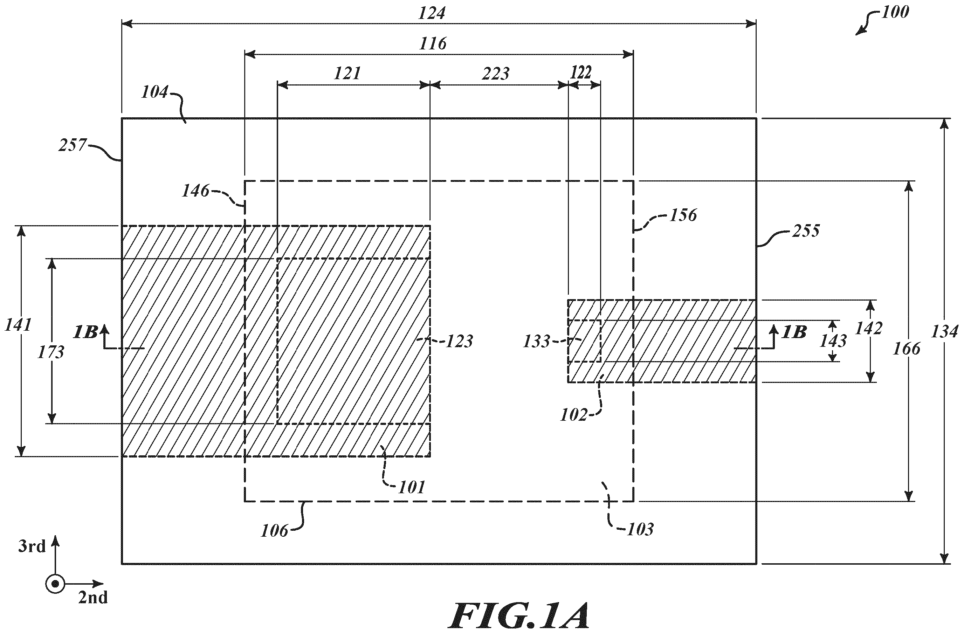

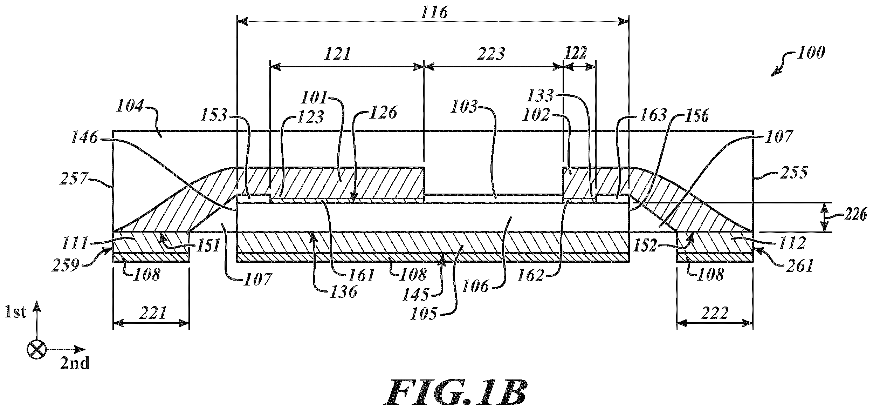

Figures 1A and 1B are top and cross-sectional views of a power package 100 including a semiconductor die 106 having a first contact 101 coupled to a first surface 126 of the die 106 and extending past a first side 146 of the die 106. A second contact 102 is coupled to the first surface 126 of the die 106 and extending past a second side 156 of the die 106. The die 106 has a dimension 226 along a first axis, a dimension 116 along a second axis, and a dimension 166 along the third axis. The first axis is transverse to the second axis and the third axis is transverse to the first axis and the second axis. In some examples, the dimension 116 is greater than the dimension 166. The first contact 101 extends past the first side 146 of the die 106 along the second axis. The second contact 102 extends past the second side 156 of the die 106 along the second axis. The die 106, the first contact 101, and the second contact 102 are under or otherwise encased within a first molding compound 104. Thus, regions of the die 106, the first contact 101, and the second contact 102 are depicted by dashed lines in Figure 1A. For ease of readability, hatch patterns have been included for the first contact 101 and the second contact 102 that are under the first molding compound 104.

In some embodiments, an insulator layer 103 covers a top portion of the die 106 between the first and second contact. A dimension 124 of the first molding compound 104 along the second axis is greater than the dimension 116 of the die. The dimension 124 extends from a first edge 257 to a second edge 255 of the package 100. The first edge 257 is coplanar with an outer surface 259 of the first contact 101 The second edge 255 of the first molding compound 104 is coplanar with an outer surface 261of the second contact 102. A dimension 134 of the first molding compound 104 along the third axis is greater than the dimension 166.

The insulator 103 includes a first opening 123 and a second opening 133 that each expose a surface of the die 106. The first opening 123 and the second opening 133 include a seed or plating layer 161, 162 on to which a conductive material is formed to create the first contact 101 and the second contact 102. In various embodiments, the conductive material may include copper, silver, gold, a metal alloy, or metallic semiconductors, or a combination thereof. The seed layers 161 and 162 may have the same material as the first and second contacts 101, 102. Generally, seed layers are formed on a wafer surface as metallization layers during a process of forming interconnections (e.g., damascene). The seed layers provide uniform electroplating on the wafer surface and enhance adhesion between the interconnections and the wafer surface. The first opening 123 has a first dimension 173 along the third axis and a second dimension 121 along the second axis. The first contact 101 has a dimension 141 along the third axis and the second contact 102 has a dimension 142 along the third axis. The dimension 141 is greater than the dimension 142, which means an area of the first contact 101 is greater than an area of the second contact 102.

The second opening 133 has a first dimension 143 along the third axis and a second dimension 122 along the second axis. An area of the first opening 123 is greater than an area of the second opening 133. The first dimension 173 of the first contact 101 is greater than the dimension143 of the second contact 102. The first contact 101 is spaced by a distance 223 from the second contact 102 along the second axis. The greater area provides less electrical resistance of the first contact 101 compared with the second contact 102. Thus, the first contact 101 is capable to carry a greater electrical current flow than the second contact 102. In some examples, the first molding compound 104 surrounding the contacts 101 and 102 dissipates excessive heat generated from a relatively high current flow is passing through the contacts 101 and 102. A greater heat dissipation benefits the package 100 to tolerate a greater electrical power for high-power applications. By utilizing contacts 101 and 102 with a relatively wide area compared with a conventional wire bonding, a broader surface of the conductive material of contacts 101 and 102 are in direct contact with the first molding compound 104. The direct contact between the first molding compound 104 and the conductive material of contacts 101 and 102 eases heat exchanges between from the contacts 101 and 102 to the first molding compound 104. Hence, a wider area of the contacts 101 and 102 enhances both heat dissipation from the contacts 101 and 102 to the first molding compound 104 as well as capability of the contacts 10a and 102 to operate in a greater electrical current flow.

The power package 100 includes a second surface 136 opposite to the first surface 126. The insulator 103 is over the first surface 126 of the die 106. The insulator 103 includes the first opening 123 and the second opening 133. The first contact 101 is coupled to the first surface 126 of the die 106 through the first opening 123. The first contact 101 is extended from the first opening 123 to pass the first side 146 of the die 106 along the second axis and is bent or curved downward with respect to the surface 126 of the die. The contact 101 has a first surface 151 that is an external surface or exposed surface from the molding compound.

The second contact 102 is coupled to the first surface 126 of the die 106 through the second opening 133. The second contact 102 is extended from the second opening 133 to pass the second side 156 of the die 106 and ends in a second surface 152. The first molding compound 104 is formed on the first and second contacts 101, 102 and on the insulator 103. A second molding compound 107 is formed between the first side 146 of die 106 and the first contact 101, and between the second side 156 of die 106 and the second contact 102.

A first portion 153 of the insulator 103 is between the first side 146 and the first opening 123 on the die. The first portion is between the first contact 101 and the second molding compound 107.

. A second portion 163 of the insulator 103 is between the second side 156 and the second opening 133. The first portion 153 of the insulator 103, the second portion 163 of the insulator 103, and the second molding compound 107 reduce mechanical stress on the extended portions of the first and second contacts 101, 102 that protect the first and second contacts 101, 102 from damage or deformation during manufacturing process and operation. Thus, a robustness of the power package 100 is enhanced by the first portion 153 and the second portion 163 of the insulator 103 and the second molding compound 107. The first molding compound 104 and the second molding compound 107 may be an encapsulant, a polymer, a resin, a dielectric, or some other type of material for encasing, covering, and protecting components of the package 100. In some examples, the insulator 103 may be formed by depositing a dielectric material using processes such as a chemical vapor deposition (CVD) process, a sub-atmospheric CVD (SACVD) process, a flowable CVD process, an atomic layer deposition (ALD) process, a physical vapor deposition (PVD) process, or other suitable process.

In various embodiments, a first conductive layer 105 is formed on the second surface 136 of the die 106. A second portion 111 of the conductive layer is formed on the surface 151 of the first contact 101. A third portion 112 of the conductive layer is formed on the surface 152 of the second contact 102. The second portion 111 includes the outer surface 259 and the third portion 112 includes the outer surface 261.

An area of the first conductive layer 105 may be same as an area of the second surface of the die 106. The area of the first conductive layer 105 is greater than an area of the second conductive layer 111 and an area of the third conductive layer 112. The area of the second conductive layer 111 is greater than the area of the third conductive layer 112 as the first contact has a greater surface area than the second contact. The first conductive layer 105 is spaced from the second conductive layer 111 by a first distance along the second axis. The first conductive layer 105 is spaced from the third conductive layer 112 by a second distance along the second axis. The first distance may be same as the second distance. The first and second contacts as well as the first, second, and third conductive layers 105, 111, 112 may be formed with copper plating techniques.

A thin conductive layer 108is formed on the conductive layer 105 and on the second and third portions of the conductive layer. A thickness of the thin film layer 108 along the first axis may be about 1 nm or less. In some embodiments, the thin film layer 108 includes tin (Sn). The tin material provides corrosion protection, solderability, and copper contact interface for the first, second, and third portions of the conductive layer 105, 111, 112. In some examples, the conductive layer may include conductive materials different than copper. For instance, the conductive materials may be selected from gold, silver, aluminum, metal semiconductors, an alloy and a combination thereof.

The second conductive layer 111 has a first dimension 221 along the second axis. The third conductive layer 112 has a first dimension 222 along the second axis. The dimension 221 may be substantially the same as the dimension 222. The dimensions 221, 222 of the outward facing contacts of each of the first and second contacts may be greater than each of the first and second distances that represent the space between these contacts and the backside of the die contact (the first portion of conductive layer 105). The second molding compound 107 on each side of the die may have a triangular shape. An outer surface of the second molding compound is coplanar with the second surface 136 of the die. A dimension of the second molding compound 107 along the third axis (not shown in Figure 1B) may be same as the dimension 134 of the first molding compound 104 described in Figure 1A. Thus, a portion of the second molding compound 107, that is not covered by of the first and second contacts 101 and 102, may be in direct contact with the first molding compound 104. A material of the first molding compound 104 may be the same as a material of the second molding compound 107. Hence, the extended portions of the first and second contacts 101, 102 are surrounded by the material of the first and second molding compounds 104, 107.

In some embodiments, the power package 100 is a quad-flat no-leads (QFN) package. The QFN package has no lead and can be coupled to a printed circuit board (PCB) by its contacts on the backside of the package. In this fashion, the conductive layer 111, 112, and 105 may be the contacts of the QFN that are formed on the backside of the power package 100 to be coupled to the surface of the PCB or other type of electrical circuit. The QFN package is compatible with a surface-mount device (SMD) technology for an electrical circuit. In this embodiment, the contacts 101 and 102 are coupled to the backside of the QFN package without wire bonding. Instead, the contacts 101 and 102 provide a broader conductive cross-section area rather than wire bonding. The broader conductive cross-section area provides lower resistance of the contacts 101 and 102 compared with a conventional wire bonding. As a result, the contacts 101 and 102 are capable to tolerate greater electrical current flow than wire bonding connections. This capability benefits high power applications, where a maximum electrical current flow is increased with increasing the cross-section area of the electrical contacts. In addition, less electrical resistance generates less temperature during a device performance. Lower temperature of the power-package 100 benefits lifetime and performance characteristic of the device inside the power-package 100. Accordingly, the first and second molding compounds 104, 107 improve a heat dissipation with covering a whole area around the first and second contacts 101, 102. The greater heat dissipation allows sufficient operation of the devices inside the power package 100 while the device is operating under a relatively high-power condition.

In various embodiments, the semiconductor die 106 may be a field effect transistor (FET) with three terminals: drain, source, and gate. In this fashion, all three terminals may be coupled to a surface of a circuit by the conductive layer 105, 111, and 112 in the backside of the package 100. In some examples, the first contact 101 may be the drain terminal of the transistor, the second contact 102 may be the source terminal of the transistor, and the first conductive layer 105 may be a gate terminal of the transistor. The drain and source terminals may be reversed for different channel types of the transistor. The gate of the transistor can control an electrical current between the drain and source. An equivalent resistance between the drain and source, when the transistor is working in an "ON" state, is known as R_{DS}. A minimized value of R_{DS} is desired for high power applications due to a direct relationship between the R_{DS} and heat generation of the transistor during an operation mode (e.g., ON state). In some examples, the resistance R_{DS} of the transistor in power-package 100 is reduced compared with a conventional package with wire bonding, due to an enlarged cross-section area of the contacts 101 and 102 rather than the wire bonding. Thus, the transistor can tolerate higher electrical current, and consequently, higher electrical power compared with conventional packages with wire bonding. In some embodiments, the die 106 may be different types of semiconductor devices including semiconductor transistors, diodes, photodetectors, and light emitting devices.

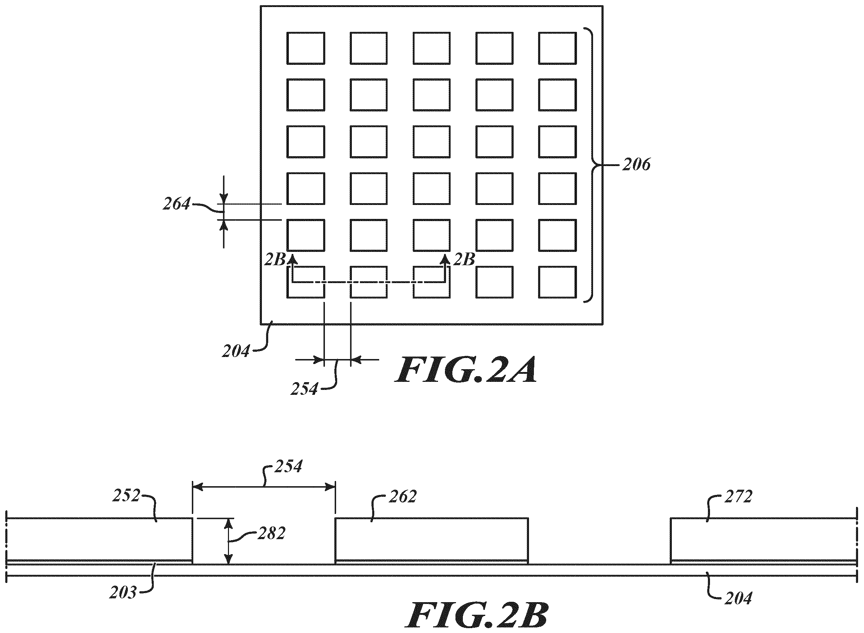

Figures 2A-7C illustrate a manufacturing process of the power package 100 described in Figures 1A-1B. In general, the manufacturing process includes steps of packaging a plurality of devices at a same time. Each device of the plurality of devices may be formed on a semiconductor die before starting the packaging process.

Figure 2A is a top plan view of a plurality of semiconductor die 206 positioned on a tape 204. Each of the plurality of die 206 may be a semiconductor die corresponding to the die 106 described in Figures 1A-1B. Each die of the plurality of die 206 is spaced from an adjacent die by a first distance 254 and a second distance 264 from an adjacent die along a different axis. In some examples, the first distance 254 may be same for all the plurality of die 206, and the second distance 264 may be same for all the plurality of die 206. The plurality of semiconductor die 206 may be formed on a common semiconductor wafer. In this fashion, the semiconductor wafer may be processed to form a plurality of electrical devices. Afterward, the plurality of die 206 corresponding to the plurality of electrical devices may be separated by a mechanical sawing technique. After sawing, the plurality of die 206 are arranged on the tape 204 along the first axis by a pick and place system or other suitable technique. The distance 254 between the plurality of die 206 may be greater than the distance 264 because contacts 101 and 102 are extending along the second axis while no electrical contacts will be formed between the dies along the third axis. For instance, the distance 254 may be designed to have sufficient space for forming an extended contact along the second axis for the die 252 and an extended contact along the second axis for the die 262 in addition to a space between the contacts for sawing and singulation of each device after the packaging process. However, the arrangement of the plurality of die 206 is not limited to the arrangement of Figure 2A and may be changed for different packaging process.

Figure 2B is a cross sectional view of a portion of Figure 2A along the line 2B-2B. In this fashion, only three die 252, 262, and 272 are depicted to more detail of the packaging process. The die 252, 262, and 272 of Figure 2B have substantially same dimensions and material properties.

In various embodiments, each of the plurality of die 252, 262, and 272 has a dimension 282. The dimension 282 may be the same for all the plurality of die. An insulator 203 is between the die 252 and the tape 204. The insulator 203 corresponds to the insulator 103 in Figure 1B.

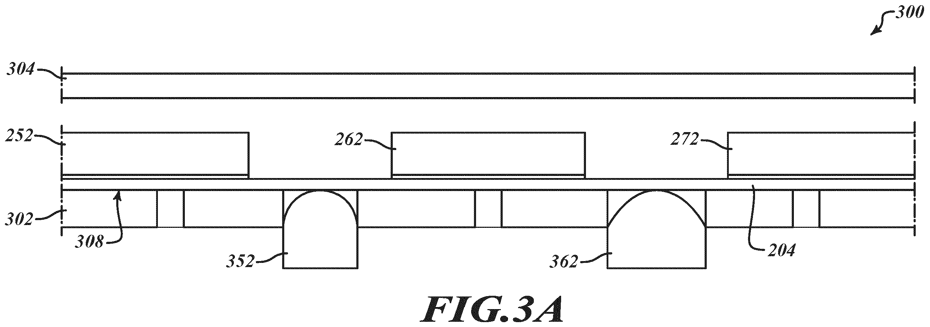

Figure 3A is a step of loading the tape 204 and the plurality of die 206 of Figure 2A inside a molding assembly 300. The molding assembly 300 includes a bottom plate 302 and a top plate 304. The tape 204 is positioned on a surface 308 of the bottom plate 302. The bottom plate 302 includes a plurality of movable bars. In Figures 3A-3C, only two of the plurality of bars 352 and 362 are shown for simplicity. The plurality of bars are aligned to a position between two adjacent dies, i.e. aligned with the distance 254 between two die. For instance, the bar 352 is positioned between the die 252 and the die 262 and the bar 362 is positioned between the die 262 and the die 272 along the second axis.

The illustrated shapes of the first bar 352 and the second bar 362 are different to show that different shapes may be used. It is envisioned that a single bar shape is likely to be used to create a curvature suitable for the final design for all packages during a packaging process. A curvature of an end of each bar creates an angle of curvature or bend in the first and second contacts once formed. The curvature can be selected by the manufacturer to meet the final design specifications of the package contacts.

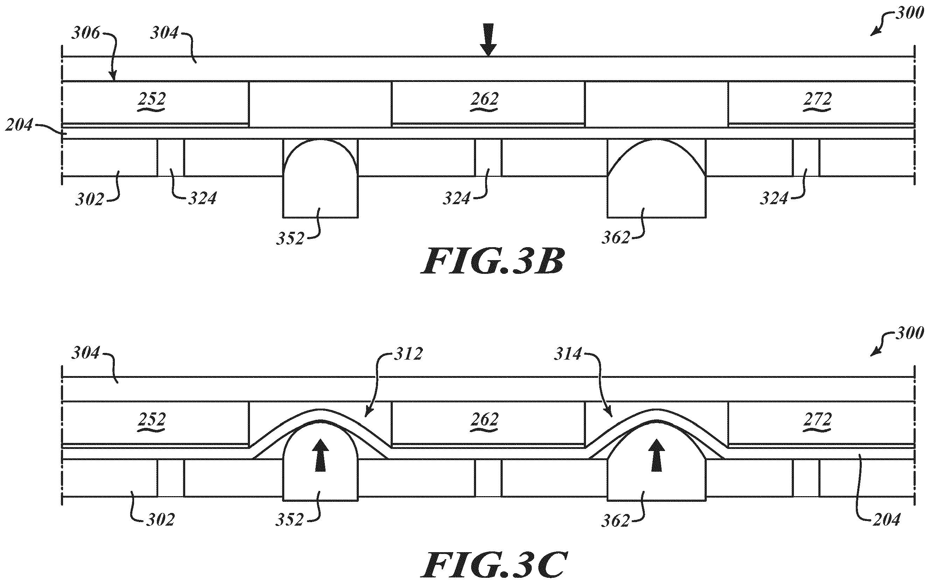

The plurality of bars (e.g., 352 and 362) are movable relative to the bottom surface 302. The plurality of bars are moved together to push the tape 204 into a space between each die, see Figure 3C. The movement of the plurality of bars may be controlled by an electro-mechanical motor and an external control system coupled to the electro-mechanical motor. A force and amplitude of the movement of the plurality of die may be adjusted based on the material of the tape 204 and the dimension 282 of the plurality of die (as described in Figure 2B).

Figure 3B is a step of fixing a position of the plurality of die in accordance with the plurality of bars. In this step, the top plate 304 is pushed on a surface 306 of the plurality of die. The surface 306 is in a same side as the second surface 136 of the die 106 in Figure 1B. In this fashion, the top plate 304 keeps the plurality of die 252, 262, and 272 in a fixed position compared with the aligned bars 352 and 362 of the bottom plate 302. In addition, the top plate 304 closes the top area of the plurality of die 252, 262, and 272 along the first axis to prevent any leakage of unwanted material (e.g., molding compound) to the surface 306 of the plurality of die 252, 262, and 272 during the molding process. In some examples, the bottom plate 302 includes a plurality of openings 324. Each of the plurality of openings 324 may be positioned between two of the plurality of bars (e.g., 352 and 362) along the second axis. A vacuum air flow may be applied to the plurality of openings 324 by an external air pump. In this fashion, the tape 204 is fixed on the bottom plate 302 by a suction force from the vacuum air flow applied through the plurality of openings 324. In some examples, the plurality of openings 324 may be discrete apertures arranged along the third axis (not shown). In this fashion, one or more apertures may be positioned below each of the plurality of die along the third axis. Alternatively, each opening of the plurality of openings 324 may be extended along third axis to apply the vacuum air flow to a plurality of die aligned in a row along the third axis. In addition, a suction flow applied to the plurality of openings 324 may vacuum the molding assembly 300 and remove any residual material from the space between the bottom plate 302 and the top plate 304.

Figure 3C is a step of shaping the tape 204 by the plurality of bars. In this step, the plurality of bars (e.g., bars 352 and 362) are upwardly pushed into the tape 204 from the bottom plate 302 to the top plate 304 along the first axis. Portions of the tape 204 that are positioned between the plurality of die (e.g., 252, 262, and 272) along the second axis takes a concave shape in accordance with the shape of each bar of the plurality of bars (e.g., 352 and 362). For instance, a shape of the tape 204 in an area 312 between the dies 252 and 262 is concaved according to the shape of the bar 352 and a shape of the tape 204 in an area 314 between the dies 262 and 272 is concaved according to the shape of the bar 362.

Afterward, a molding compound corresponding to the second molding compound 107 in Figures 1A-1B is injected into the space between the bottom plate 302 and top plate 304 of the molding assembly 300 to fill the areas (e.g., 312 and 314) between the plurality of die (e.g., 252, 262, and 272). In some examples, the molding compound may be high-viscosity liquid when filling the spaces between the bottom plate 302 and top plate 304 of the molding assembly 300, and is then cured by cooling down in a cooling step. After injecting the molding compound, the tape 204 and plurality of die may remain inside the molding assembly 300 for a period of time for the cooling step. In the cooling step, the molding compound is cooled down to change the high-viscosity liquid phase of the molding compound to a solid phase. When the molding compound is solid, the bars 352 and 362 return to a primary position and the top plate 304 releases the plurality of die to be removed from the molding assembly 300.

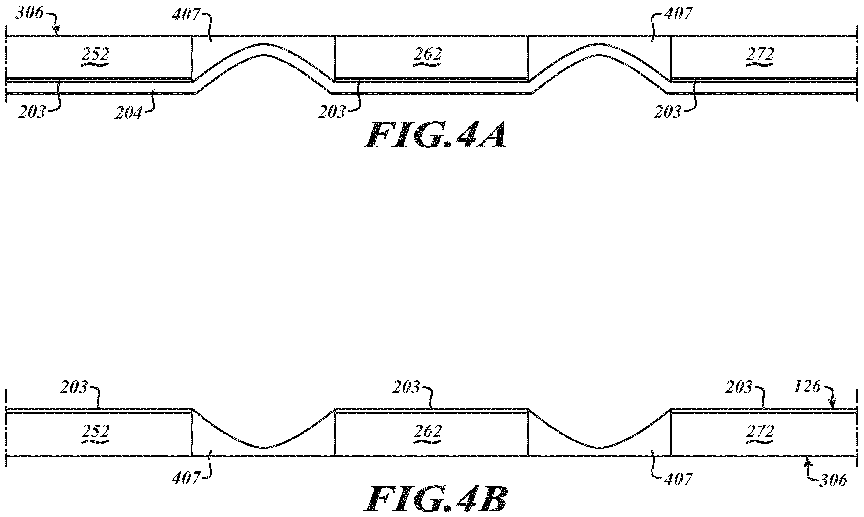

Figure 4A is a portion of the plurality of die (e.g., 252, 262, and 272) on the tape 204 after removing from the molding assembly 300 in Figure 3C. In this step, a detaping process may be performed with a detaping machine to remove the tape 204 from the plurality of die (e.g., 252, 262, and 272) and the molding compound 407 formed between the dies. The molding compound 407 is solid, thus may not be deformed after removing the tape 204. The molding compound 407 is corresponding to the second molding compound 107 described in Figure 1B. The concave shape of the molding compound 407 provides a desired curve to form the extensions of contacts 101 and 102 described in Figure 1B.

As described in Figure 2B, the insulator 203 corresponds to the insulator 103 on the first surface 126 of the die 106 in Figure 1B. The first surface 126 of the die 106 in Figure 1B is positioned on top of the package 100 along the first axis to form the first contact 101 and the second contact 102 on the top portion. Hence, to process the packaging of the plurality of die (e.g., 252, 262, and 272) to form a device within the package 100 in Figure 1B, the plurality of die (e.g., 252, 262, and 272) is flipped as shown in Figure 4B. In this fashion, the insulator 203 is on the first surface 126 of the die 106 in Figure 1B upon which the first and second contacts 101, 102 should be formed. The surface 306 of the plurality of die (e.g., 252, 262, and 272) is faced down along the first axis to form backside of the device within the package 100 in Figure 1B.

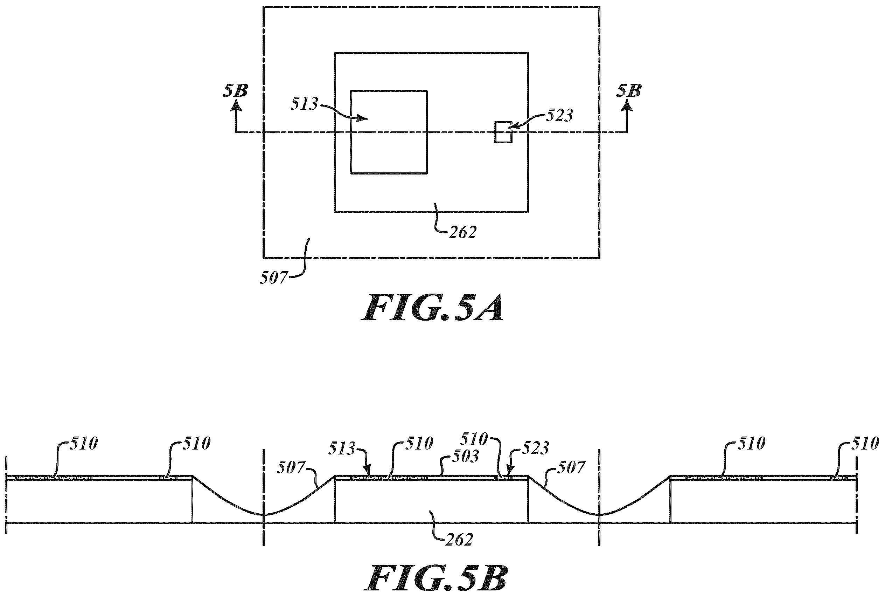

Figures 5A-5B show a step of processing the insulator layer 503 corresponding to the insulator 203 in Figure 4B. Figure 5A is a top plan view of a die 262 corresponding to the die 106 and a molding compound 507 corresponding to the second molding compound 107 in Figure 1B. The die 262 is die 262 described in Figure 4B. In this step, a first opening 513 and a second opening 523 are formed in the insulator layer 503 to expose an active surface of the die. The first opening corresponds to the first opening 123 in Figures 1A-1B and the second opening 523 corresponds to the second opening 133 in Figures 1A-1B. Thus, dimensions of the first and second openings 513, 523 are corresponding to the dimensions of the first and second openings 123, 133 described in Figures 1A-1B.

Figure 5B is a cross-section view of the plurality of die (e.g., 252, 262, and 272) and molding compound 507 therebetween as described in Figure 4B, after forming openings 513 and 523 on each die of the plurality of die. The openings 513 and 523 may be formed by etching techniques. The first openings 513 define position of the first contact 101 and the second opening 523 define position of the second contact 102 of the power package 100 in Figures 1A-1B. Dimensions of the first opening 513 and the second opening 523 may be same for all the plurality of die.

In some examples, the etching process may include any suitable etching technique such as wet etching, dry etching, Reactive-ion etching (RIE), ashing, and/or other etching methods. In some embodiments, etching includes multiple etching steps with different etching chemistries, where each step targeting a particular material. For example, a dry etching process may implement an oxygen containing gas, a fluorine-containing gas (e.g., CF4, SF, CH, F2, CHF3, and/or C2F6), a chlorine-containing gas (e.g., C12, CHC13, CC14, and/or BC1z), a bromine-containing gas (e.g., HBr and/or CHBR3), an iodine-containing gas, other suitable gases and/or plasmas, and/or combinations thereof. In addition, a wet etching process may include etching in diluted hydrofluoric acid (DHF); potassium hydroxide (KOH) solution; ammonia; a solution containing hydrofluoric acid (HF), nitric acid (HNO3), and/or acetic acid (CH3COOH); or other suitable wet etchants.

Figure 5B also includes a step of filling the openings 513 and 523 with a seed or plating conductive layer 510. This layer may fill the opening or may only partially fill the openings. The seed conductive layer 510 corresponds to seed layers 161 and 162 in Figure 1B. In some examples, the seed conductive layer 510 is a copper seed layer. The copper seed layer may be formed by a chemical vapor deposition (CVD) process, a sub-atmospheric CVD (SACVD) process, a flowable CVD process, an atomic layer deposition (ALD) process, a physical vapor deposition (PVD) process, or other suitable process. A thickness of the seed conductive layer 510 may be less than or same as a thickness of the insulator layer 503 along the first axis. In some embodiments, the thickness of the seed conductive layer 510 along the first axis may less than or equal to 10 nm.

After forming the seed conductive layer 510, a photoresist layer (not shown) is formed on the plurality of die (e.g., 252, 262, and 272 described in Figure 4B) and the molding compound 507 therebetween. In this fashion, the photoresist layer is formed to create a desired pattern for copper plating of the contacts 101, 102 described in Figure 1B. In some examples, the photoresist deposition and the pattern creation may be based on a photolithography process. In a photolithography process, the photoresist layer is formed conformally on the plurality of die and the molding compound therebetween by a coating technique. The coating technique may include evaporation, sputtering, CVD, or other suitable techniques. Afterward, a designed mask may be aligned to the photoresist layer along the first axis to create the desired pattern by exposing a UV (ultraviolet) light on the photoresist layer. After the UV light exposure, the patterned portions may be removed by a dry or wet etching technique. Then the copper plating is formed on the patterned photoresist and the remaining photoresist can be removed from the plurality of die (e.g., 252, 262, and 272 described in Figure 4B) and the molding compound 507 therebetween.

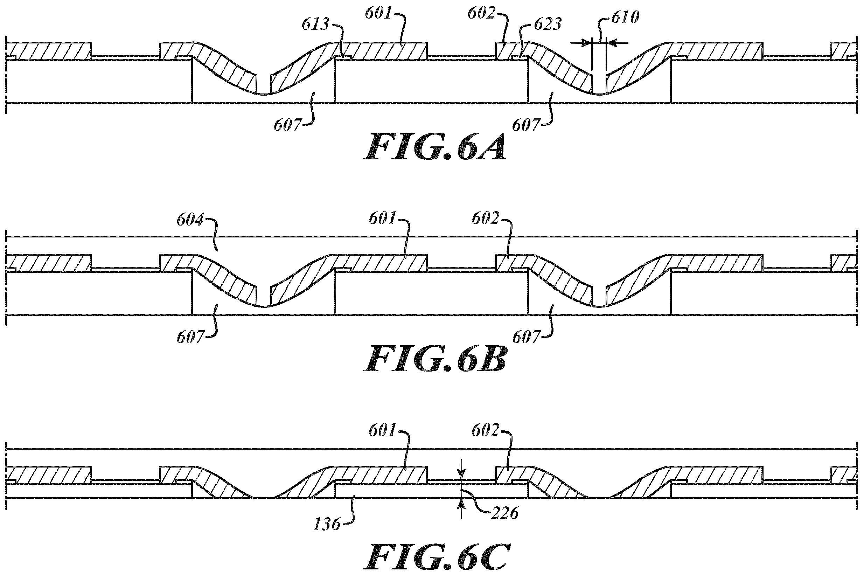

Figure 6A shows the plurality of the dies (e.g., 252, 262, and 272 described in Figure 4B) after copper plating to form the first and second contacts 601, 602 and photoresist removal. The first contact 601 and the second contact 602 correspond to the first contact 101 and the second contact 102 in Figure 1B. A molding compound 607 corresponds to the second molding compound 107 in Figure 1B. The shape of the molding compound 607, that is created in the process described Figure 3C, causes a curved shape of the contacts 601 and 602. In addition, portions of insulator 613 and 623, that correspond to the portions 153 and 163 in Figure 1B, support the contacts 601 and 602 in a region of bending or curvature. The bending of the copper plating forms a tail of each of the contacts 601 and 602 on the molding compound 607. The tails of the contacts 601 and 602 have a distance 610 from a contact of an adjacent die along the second axis. The distance 610 is designed to ease a singulation process after the packaging steps.

In a step of Figure 6B, a molding compound 604 is formed on the plurality of die and the contacts 601, 602 described in Figure 6A along the first axis. The molding compound 604 corresponds to the first molding compound 104 in Figure 1B. The molding compound 604 covers the contacts 601, 602 as well as the tails of the copper plating. In this fashion, the tails of the contacts 601, 602 are enclosed between the molding compound 604 and the molding compound 607. Hence, shape of the tails of the contacts 601, 602 are fixed between the molding compounds 604, 607 that reduce mechanical stress on the copper plating. The molding compounds 604, 607 surrounding the contacts 601, 602 improve heat dissipation during an operation mode. Higher heat dissipation increases capability to tolerate higher electrical current passing through the contacts 601, 602. In some examples, the molding compound 604 may be formed in a molding assembly same as the molding assembly 300 described in Figure 3A.

Figure 6C is a step of preparing backside of the plurality of die along the first axis to form backside conductive layers 105, 111, and 112 described in Figure 1B. In this step, a thickness of each die of the plurality of die along the first axis is thinned to a desired dimension. A thinning process prepares the second surface 136 of the die 106 to be coupled to the first conductive layer 105 in Figure 1B as well as the portion of contacts to be coupled to the backside conductive layers 111 and 112 in Figure 1B. The thinning process may be performed by grinding the backside of the plurality of die along the first axis.

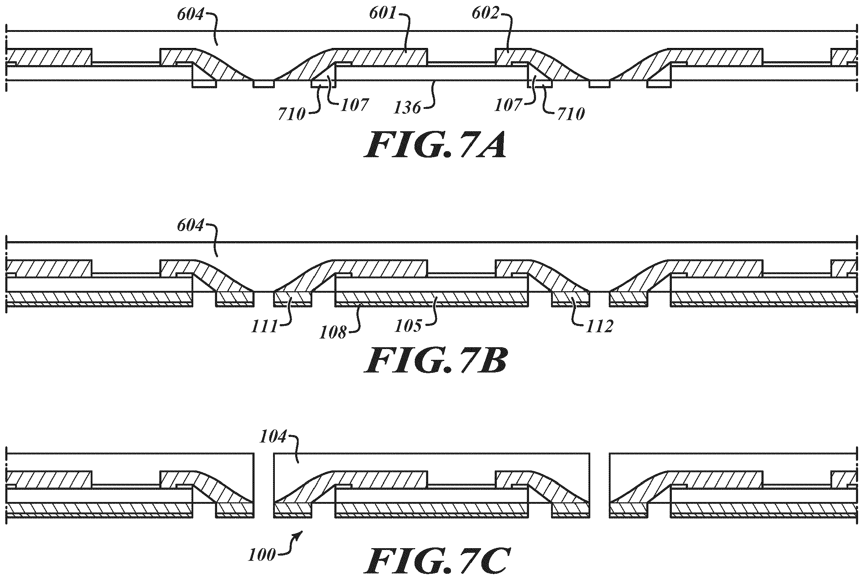

Figure 7A is a step of photolithography process to form backside conductive layers 105, 111, and 112 described in Figure 1B. The photolithography step may be same as the step described in Figure 5B. In this step, a photoresist 710 is deposited on the second surface 136 of the plurality of die. The photoresist 710 is then removed from the tail portions of contacts 601, 602 and the surface 136 of each of the plurality of die for creating the conductive layers 105, 111, and 112 of Figure 1B. The photoresist may be patterned in a same process as described in Figure 5B. In some examples, a seed copper layer can be deposited before copper plating, same as the step of forming the copper seed layer described in Figure 6A. The seed layer may be formed by a metal sputtering process before the photoresist deposition step. After patterning the photoresist 710, a conductive layer (e.g., copper plating) may conformally be deposited on the surface 136 of the plurality of die, the tail portions of contacts 601, 602, and the photoresist 710. After copper plating, the remained photoresist and the metal seed under the photoresist are removed with a wet or dry etching technique. In this fashion, the process of photolithography for copper plating known as a lift-off method and the photoresist 710 is a sacrificial layer of the lift-off process.

Figure 7B shows the plurality of die after copper plating and photoresist removal. In this step, the conductive layers 105, 111, and 112 are formed with a lift-off method as described in Figure 7A. In some embodiments, a tin (Sn) layer is deposited on the conductive layers corresponding to the thin film layer 108 in Figure 1B. The tin layer 108 may be deposited before the step of photoresist removal in the lift-off process described in Figure 7A. The tin layer 108 enhances an adhesion of the conductive layers 105, 111, and 112 for surface mounting technology. A thickness of the tin layer 108 along the first axis may be the same for the conductive layers 105, 111, and 112 of the plurality of die.

Figure 7C is a step of singulation of the plurality of die to make a single power package 100 described in Figure 1B. In this step each device is separated from an adjacent die along the second axis by sawing or any cutting techniques. A space 610 described in Figure 6A is a portion of molding compound 604 to be sawed during the singulation process. In this fashion, each device after singulation includes three conductive contacts (corresponding to the conductive layers 105, 111, and 112) on the backside of the package. The contacts are designed to be mounted on a surface of an electrical circuit. Hence the power package can form a quad-flat no-leads (QFN) package with planar copper contacts. The no-leads packages may be mounted on a circuit without through-holes.

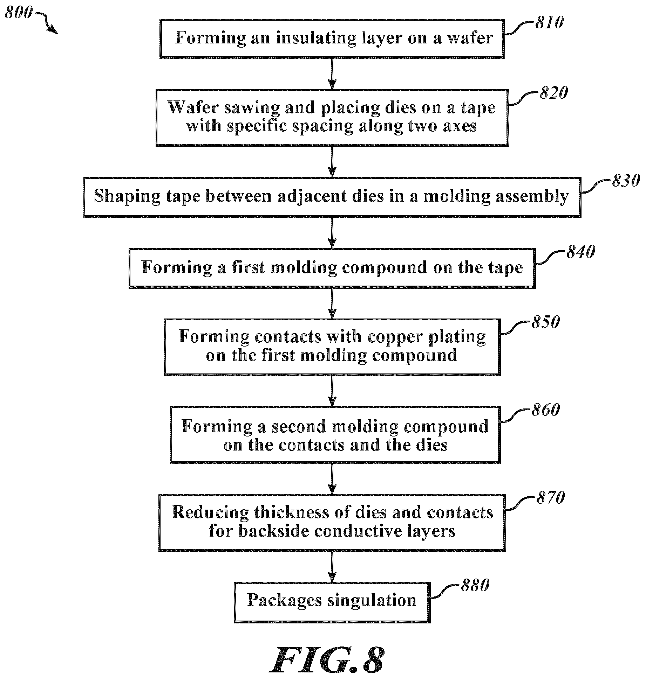

Figure 8 is a flowchart 800 of a method of forming the power package described in Figures 2-7. In some examples, the method described in flowchart 800 may be performed by one or more operators. Alternatively, a portion of the steps or whole steps may be performed automatically with an executable program on a manufacturing machine. Order of the steps may change for different devices based on the devices type within the packages, manufacturer preference of instruments availability, and/or design of the packages.

In step 810, an insulator layer is formed on a wafer. The wafer may be processed prior starting the step 810. A plurality of devices may be formed inside the wafer by different doping process (e.g., creating p-type and n-type regions for transistor devices). The insulator layer may correspond to the insulator 103 describe in Figure 1A. In some examples, a material of the insulator may be a polymer. In this fashion, the polymer may include polyimide. In addition, the polymer material may include a combination of polyimide and polybenzoxazole. A thickness of the insulator layer may be designed based on the device application (e.g., based on the required threshold voltage and gate oxide capacitance for a transistor). In some examples, the insulator layer may be formed by depositing a dielectric material using processes such as a chemical vapor deposition (CVD) process, a sub-atmospheric CVD (SACVD) process, a flowable CVD process, an atomic layer deposition (ALD) process, a physical vapor deposition (PVD) process, or other suitable process.

In step 820, the plurality of devices formed in the wafer of step 810 are separated by a mechanical sawing technique. After the sawing process, the plurality of devices may be placed on a tape with a pick and place system. The plurality of die are arranged with specific distances along two axes (e.g., second and third axes) as described in Figure 2A. The distances in one axis (e.g., second axis) are designed based on the dimensions of contacts 101 and 102 as described in Figure 1B. The distances in another axis (e.g. third axis) may depend on the sawing technique to provide enough space for a safe singulation without damaging the die of the device and the molding compounds surrounding the die.

In step 830, the plurality of die on the tape of step 820 are moved into a molding assembly. The tape allows moving the plurality of die together by a fixed position compared with each other on the tape. In addition, the tape is a flexible structure that benefits shaping a molding structure. Hence, in step 830, portions of the tape between the dies are bent by a plurality of bars to shape the tape (corresponding to Figure 3C). The shape of the tape may be the same or different in different spaces between the plurality of die.

In step 840, a high-viscosity liquid molding compound is injected inside the spaces between the plurality of die (over the shaped tape). A top plate may be placed on the top surface of the dies in the molding assembly to prevent leakage of the molding compound to the surface of the dies. The liquid phase of the molding compound may turn into a solid phase after a cooling process. Thus, by cooling down the molding compound, a solid molding compound is formed on the shaped tape between the plurality of die. In this fashion, a first molding compound forms with a concave shape between the dies of the plurality of die, due to the concave shape of the tape between the dies.

In step 850, the tape is removed from the plurality of die (detaping) and the first molding compound therebetween to form contacts (corresponding to Figures 4A-6A). The contacts may be formed by forming openings on an insulator layer of the dies and forming a copper seed inside the openings. Next, a copper plating process forms the contacts and associated tails of each contact on the concave shape molding compound. The tails of the contacts on the concave shape molding compound extends the device contacts from a top surface of the die to planar contacts in the backside of a package that benefits a surface mounting device (SMD).

In step 860, a second molding compound is formed on top of the die, contacts, and associated tails of the contacts (corresponding to Figure 6B). In this fashion, the tails of the contacts that are formed over the concave shape molding are enclosed between the first and second molding compound. Hence, the tails of the contacts are mechanically strong against any excessive stress. In addition, surrounding molding compounds benefits heat dissipation in operation mode of the device which consequently increase maximum power toleration of the package.

In step 870, a thickness of the die, length of the tails of the contacts, and a thickness of the first molding compound is reduced (corresponding to Figures 6C-7B). This thinning step prepares the device to form backside conductive layers with copper plating. The thinning may be performed by a grinding technique. The grinded surfaces of the die and tails of the contacts provide better adhesion to conductive layers. After grinding, a first conductive layer is formed on the backside of the die and a second and third conductive layers are formed on the tails of contacts. After forming the backside conductive layers, a tin (Sn) layer may be formed on the conductive layers to ease the connection of the device into a circuit with a surface mounting technique.

In step 880, a mechanical sawing singulates each of the plurality of devices (corresponding to Figure 7C). After singulation, each device may be tested and prepared for mounting on a surface of a circuit. The package can form a quad-flat no-leads (QFN) package with planar copper contacts that is sufficient for a high-power application. The no-leads packages can be mounted on a circuit without through-holes. Using the copper plating structure (e.g., tails of the contacts) instead of conventional wire bonding technique increases a maximum power of the package.

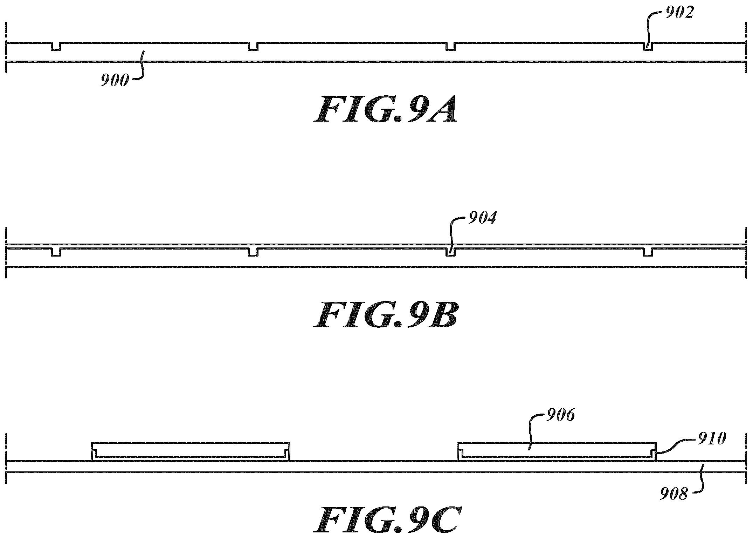

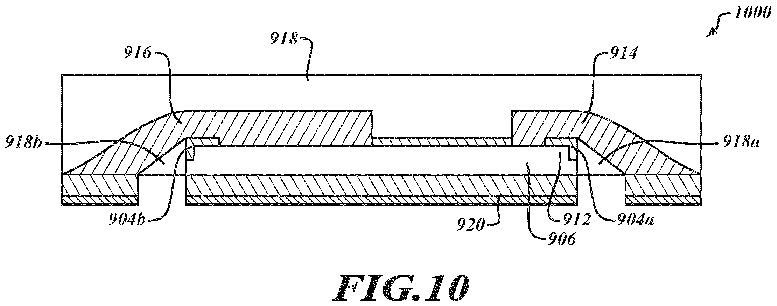

Figures 9A-9C and Figure 10 are cross-sectional views of an embodiment of the present disclosure. In Figure 9A, a wafter 900, which can be a semiconductor, includes a plurality of openings 902. The openings 902 are formed through a half cut sawing process or other technique to form the openings with an interior surface that is in an intermediate portion of the wafer 900.

In Figure 9B, a layer 904 is formed on the wafer 900 and in the openings 902. The layer may be a polyimide or polybenzoxazoles layer. A thickness of the layer is in the range of 5 and 30 nanometers.

In a step not illustrated, die 906 are separated or diced form each other by cutting through the openings 902. The individual die 906 are then placed on a tape or support 908 in Figure 9C. After the cutting, sidewalls 910 of each die 906 include both a portion of the semiconductor and a portion of the layer that are coplanar with each other.

Figure 10 is a package 1000 that includes the die 906, which includes corners 912 covered by the layer 904. A first contact 914 is coupled to the die 906 at a first location and a second contact 916 is coupled to the die 906 at a second location. The first contact 914 overlaps and may be in contact with the layer 904a at the corner 912 of the die 906. The second contact 916 overlaps and may be in contact with a second portion 904b of the layer. Molding compound 918 is on the first and second contacts and on the die. A first portion 918a of the molding compound is between the first contact 914 and a sidewall of the die 906. The first portion 918a is in contact with the sidewall of the semiconductor and with the sidewall of the layer 904a. A second portion 918b of the molding compound is between the second contact 914 and a sidewall of the die 906. The second portion 918b is in contact with the sidewall of the semiconductor and with the sidewall of the layer 904b. A stack of conductive layer 920 are formed on the die and on the first and second contacts.

The various embodiments described above can be combined to provide further embodiments. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A device, comprising:
a package including:
a die having a first surface opposite to a second surface and a first side opposite to a second side;
a first contact coupled to the die at the first surface and extending past the second surface of the die, the first contact covering a first area of the die at the first surface;
a second contact coupled to the die at the first surface and extending past the second surface of the die, the second contact covering a second area of the die at the first surface, the first area being larger than the second area;
a first molding compound between the first side of the die and the first contact, and between the second side of the die and the second contact; and
a second molding compound on the first surface of the die and on the first and second contacts.

2. The device of claim 1, further comprising:
a first conductive layer on the second surface of the die;
a second conductive layer coupled to the first contact; and
a third conductive layer coupled to the second contact, the first conductive layer is coplanar with the second conductive layer and the third conductive layer.

3. The device of claim 2 wherein the first conductive layer is spaced from the second conductive layer by a first distance in a first direction, and is spaced from the second conductive layer by a second distance in the first direction.

4. The device of claim 3 wherein the first and second contacts are copper.

5. The device of claim 2 wherein an area of the first conductive layer is greater than an area of the second conductive layer.

6. The device of claim 2 wherein and the area of the second conductive layer is greater than the area of the third conductive layer.

7. The device of claim 3 wherein the first and second contacts and first, second, and third conductive layers are copper plating.

8. The device of claim 1, further comprising an insulator layer between the first contact and the second contact on the first surface of the die, and the second molding compound is on the insulator layer.

9. The device of claim 8 wherein the insulator layer is between an extension of the first contact and the first surface of the die, and the insulator layer is between an extension of the second contact and the first surface of the die.

10. A method, comprising:
forming an insulator layer on a first surface of a die;
forming a first molding compound on a first side and a second side of the die, the first and second sides being transverse to the first surface of the die;
forming a first opening and a second opening on the insulator layer;
forming a first contact from the first opening and extending over the first molding compound;
forming a second contact from the second opening and extending over the first molding compound; and /
forming a second molding compound on the die and on the first and second contacts, a portion of each of the first and second contacts being enclosed between the first molding compound and the second molding compound.

11. The method of claim 10, further comprising:
thinning a surface of the die, the first molding compound, and ends of the first and second contacts;
forming a first conductive layer on the thinned surface of the die;
forming a second conductive layer on the thinned surface of the end of the first contact; and
forming a third conductive layer on the thinned surface of the end of the second contact, the first, second, and third conductive layers being coplanar.

12. The method of claim 11 wherein the first and second contacts and first, second, and third conductive layers are copper plating.

13. The method of claim 12, further comprising forming a tin (Sn) layer on an outer surface of the first, second, and third conductive layers.

14. The method of claim 11 wherein the end of the first contact is extended to the second conductive layer opposite to a direction that the end of the second contact.

15. The method of claim 14 wherein an area of the first conductive layer is greater than an area of the second conductive layer, and the area of the second conductive layer is greater than an area of the third conductive layer.

16. The method of claim 10, further comprising forming a concave shape of the first molding compound with a tape.

17. The method of claim 10 wherein the insulator layer is one of polyimide and polybenzoxazole.

18. A power package, comprising:
a die having a first surface opposite to a second surface and a first side opposite to a second side;
a first contact having a first end coupled to the first surface of the die and a second end that extends past the die;
a second contact having a first end coupled to the first surface of the die and a second end that extends past the die;
a first molding compound between the first side of the die and the first contact, and between the second side of the die and the second contact;
a second molding compound on the first surface of the die and the first and second contacts;
a first conductive layer coupled to the second surface of the die;
a second conductive layer coupled to the second end of the first contact; and
a third conductive layer coupled to the second end of the second contact.

19. The power package of claim 18 wherein a first area of the first contact is greater than a second area of the second contact.

20. The power package of claim 18 wherein the first conductive layer is coplanar with the second and third conductive layers, an area of the first conductive layer is greater than an area of the second conductive layer, and the area of the second conductive layer is greater than an area of the third conductive layer.
